# EUROPEAN PATENT SPECIFICATION

(11) **EP 0 420 183 B1**
(45) Date of publication and mention of the grant of the patent: **31.01.1996**
(21) Application number: 90118465.5
(22) Date of filing: 26.09.1990
(51) Int. Cl.: H03F 1/32, H03F 3/30

(54) **Push-pull circuit**
Gegentaktschaltung
Circuit push-pull

(30) Priority: 27.09.1989 JP 249076/89
(43) Date of publication of application: 03.04.1991
(73) Proprietor: KABUSHIKI KAISHA TOSHIBA, Kawasaki-shi, Kanagawa-ken 210, Tokyo (JP)
(72) Inventor: Yoshinaga, Yoshiro, c/o Intellectual Property Div., Minato-ku, Tokyo 105 (JP)
(74) Representative: Lehn, Werner, Dipl.-Ing.

(56) References cited:
- EP-A- 0 297 639
- EP-A- 0 318 396
- US-A- 4 570 128
- US-A- 4 737 732

## Description

The present invention relates to a push-pull circuit of the type described in the preamble part of claim 1.

Generally, a push-pull circuit is used in an output circuit of a semiconductor integrated circuit.

A push-pull circuit of the type mentioned hereinabove is disclosed in US-A-4 737 732.

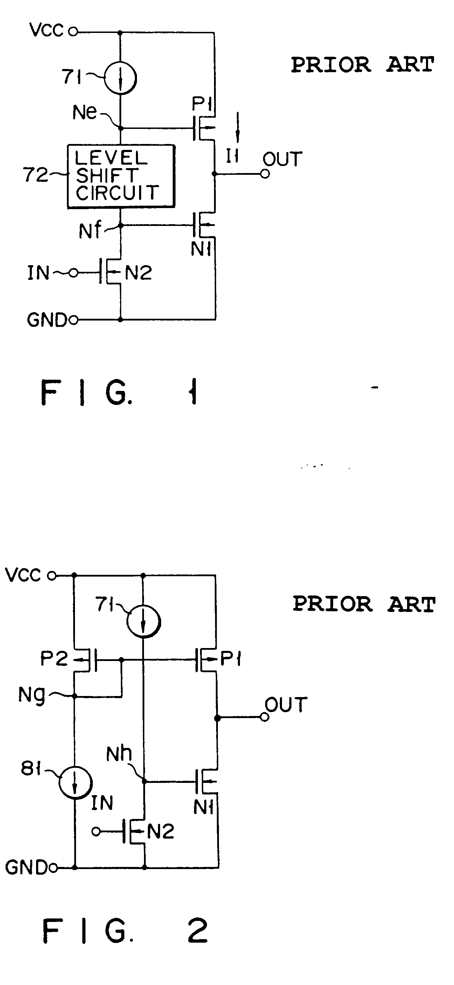

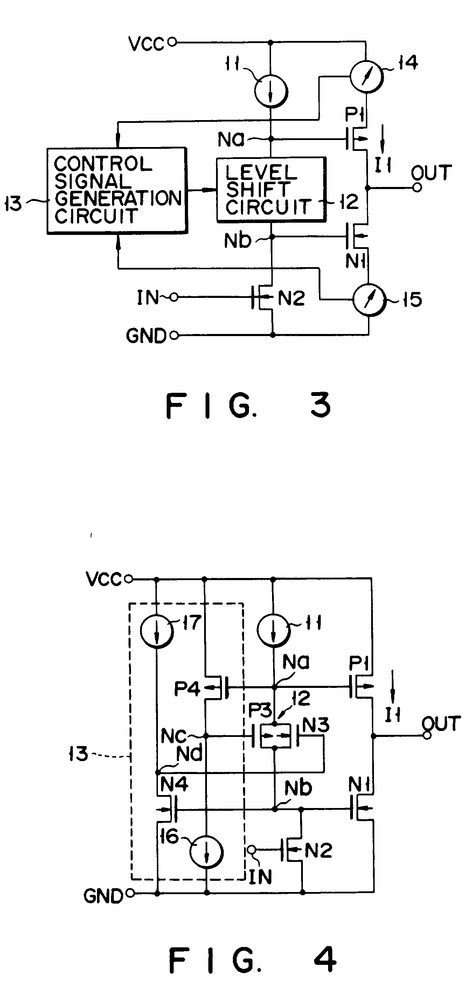

Moreover, a conventional push-pull circuit is explained below with reference to Figs. 1 and 2 of the drawings.

As shown in Fig. 1, a P-channel MOS transistor P1 and an N-channel MOS transistor N1 are serially connected between a power source potential Vcc and a ground potential GND to constitute a push-pull output stage circuit. An output terminal OUT is connected to a connection node between the P-channel MOS transistor P1 and N-channel MOS transistor N1. Further, a current source circuit 71, a level shift circuit 72 and an N-channel MOS transistor N2 are serially connected between the Vcc potential and GND potential. The gate of the N-channel MOS transistor N2 for output control is connected to an input terminal IN to which an input signal is supplied. A connection node Ne between the current source circuit 71 and the level shift circuit 72 is connected to the gate of the P-channel MOS transistor P1. A connection node Nf between the level shift circuit 72 and the N-channel MOS transistor N2 is connected to the gate of the N-channel MOS transistor N1.

The push-pull output circuit shown in Fig. 2 is different from that of Fig. 1 in that the level shift circuit 72 is omitted, and a P-channel MOS transistor P2 and a second current source circuit 81 are connected between the Vcc potential and the GND potential. The gate of the N-channel MOS transistor N2 is connected to the input terminal IN. A connection node Ng between the gate and drain of the P-channel MOS transistor P2 is connected to the gate of the P-channel MOS transistor P1. A connection node Nh between the first current source circuit 71 and the N-channel MOS transistor N2 is connected to the gate of the N-channel MOS transistor N1.

In the push-pull output circuit of Fig. 1, the level shift amount (a difference between the potential of the node Ne and the potential of the node Nf) of the level shift circuit 72 is fixed and cannot be adjusted. Therefore, the bias voltage (voltage between the source and gate) of the two MOS transistors P1 and N1 varies substantially in proportion to variation in the Vcc potential. As a result, an ineffective current (which is a current flowing in the MOS transistors P1 and N1 when the output terminal OUT is set in the electrically floating state; static current; DC current) flowing in the two MOS transistors P1 and N1 constituting the push-pull output stage circuit will vary. Thus, the power consumption in the push-pull output circuit varies and the characteristic of the circuit also varies. Therefore, in the push-pull circuit of Fig. 1, it is necessary to use a constant voltage source whose output voltage is stable. Further, the ineffective current flowing in the push-pull output stage circuit may be largely influenced by variation in the threshold voltage of the MOS transistors P1 and N1. When attempts are made to suppress variation in the ineffective current, the process control may become severer or the yield of the semiconductor device will be lowered.

In the push-pull output circuit of Fig. 2, the P-channel MOS transistors P1 and P2 are connected in a current mirror configuration. The gate of the P-channel MOS transistor P1 is always applied with a constant bias voltage from the gate of the P-channel MOS transistor P2, thereby causing a constant current to always flow in the P-channel MOS transistor P1. As a result, the maximum value of the output current in the push-pull output circuit becomes equal to that of a constant current flowing in the P-channel MOS transistor P1. Therefore, when a large output current is required, it becomes necessary to set the ineffective current at the time of no load to a large value, making a power consumption larger.

It is an object of the present invention to provide a push-pull circuit of the type as mentioned hereinabove, having characteristics that the amplitude of the output signal is large, the distortion of the output signal is small and the output current is large, and having an improved performance.

According to the present invention, this object is solved by providing the features of the characterizing part of claim 1.

Further improvements of the invention are specified in the other claims.

A push-pull circuit according to the invention may comprise an output circuit having first and second transistors whose current paths are serially connected between a first potential and a second potential, and potenial difference setting means for detecting a current level of at least one of currents flowing in the first and second transistors and setting a potential difference between signals supplied to the control terminals of the first and second transistors according to the result of detection. With the push-pull circuit according to above structure, a current flowing in the output circuit is detected and a potential difference between the signals supplied to the control terminals of the two transistors is controlled according to the result of detection.

With the push-pull circuit according to the present invention, it becomes possible to keep an ineffective current flowing in the transistors of the output stage circuit constant, irrespective of or less influenced by variations in the power source voltage and the characteristics of the transistors. The push-pull circuit according to the invention has a high performance.

Preferred embodiments of the invention are described in more detail hereinbelow in conjunction with the accompanying drawings, in which
Figs. 1 and 2 are circuit diagrams showing the construction of the conventional push-pull output circuits;
Fig. 3 is a diagram showing the construction of one embodiment of a push-pull output circuit according to this invention;
Fig. 4 is a circuitdiagram showing a concrete example of the push-pull output circuit of Fig. 3;
Fig. 5 is a diagram showing the characteristic between the gate-source voltage VGS and the drain current of a transistor in the push-pull output stage circuit of Fig. 4;
Fig. 6 is a characteristic diagram showing the relation between the ineffective current in the transistor of the push-pull output stage circuit of Fig. 4 and a control signal of a control signal generating circuit;
Fig. 7 is a diagram showing the relation between the power source voltage and the bias voltage VGS of the MOS transistor P1 in the push-pull output circuit of Figs. 1 and 4;
Fig. 8 is a diagram showing the relation between the power source voltage and a current flowing in the MOS transistor P1 of Figs. 1 and 4; and
Figs. 9 to 12 are diagrams showing modifications of the push-pull output circuit according to one embodiment of this invention.

There will now be described a push-pull output circuit according to one embodiment of this invention with reference to the accompanying drawings.

Fig. 3 shows a push-pull output circuit of CMOS structure used in the output circuit of a semiconductor integrated circuit which requires a large amplitude characteristic, less distortion characteristic and large output current characteristic.

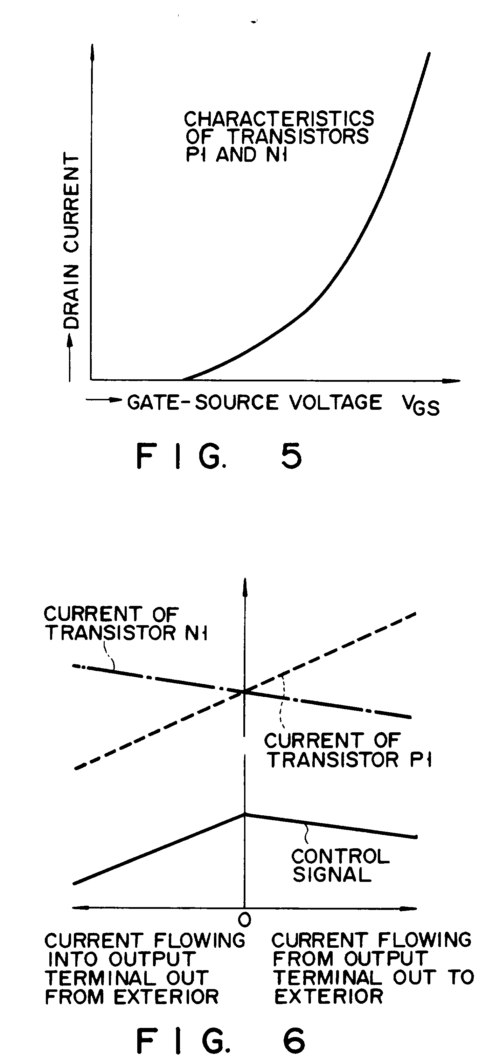

The push-pull output circuit includes a push-pull output stage circuit constituted by a P-channel MOS transistor P1 and an N-channel MOS transistor N1 which are serially connected between a power source potential Vcc and a ground potential GND. The MOS transistors P1 and N1 have complementary characteristics. Further, as shown in Fig. 5, when the gate-source voltage VGS increases, the drain current increases in a quadratic manner.

Further, the push-pull output circuit includes a first constant current source circuit 11, level shift circuit 12 and N-channel MOS transistor N2 for output control which are serially connected between the Vcc potential and the GND potential.

A connection node Na between the first constant current source circuit 11 and level shift circuit 12 is connected to the control electrode (gate) of the MOS transistor P1. A connection node Nb between the level shift circuit 12 and output controlling MOS transistor N2 is connected to the gate of the MOS transistor N1.

Further, the push-pull output circuit includes a control signal generation circuit 13. In the drawing, reference numerals 14 and 15 denote circuits for detecting currents flowing in the two MOS transistors P1 and N1 of the push-pull output stage circuit and constituting part of the control signal generation circuit 13.

Next, the operation of the circuit of Fig. 3 is explained.

First, a general operation is explained.

The MOS transistor N2 is turned on or off according to the level of a signal supplied to the input terminal IN. The gate potentials of the MOS transistors P1 and N1 vary according to the on-off operation of the MOS transistor so that the resistance of the current paths of the MOS transistors P1 and N1 may be changed. As a result, an output signal having a level corresponding to the level of the input signal is output from the output terminal OUT. The potential of the output signal greatly varies between the ground potential GND and the power source potential Vcc.

The level shift circuit 12 adjusts (changes) the level shift amount (a potential difference between the nodes Na and Nb) according to a control signal supplied from the control signal generation circuit 13. The control signal generation circuit 13 detects the current level of a current flowing in the MOS transistors P1 and N1 by means of the circuits 14 and 15. The control signal generation circuit 13 supplies a control signal to the level shift circuit 12 to control the level shift amount of the level shift circuit 12 according to the detected current values so as to keep ineffective currents flowing in the MOS transistors P1 and N1 constant. For example, the control signal generation circuit 13 increases the level shift amount when the current level flowing in the MOS transistors P1 and N1 is raised. As a result, the gate-source voltage (bias voltage) of the MOS transistors P1 and N1 is lowered, thereby causing the current flowing in the MOS transistors P1 and N1 to be reduced. On the other hand, the control signal generation circuit 13 reduces the level shift amount when the current level of a current flowing in the MOS transistors P1 and N1 is lowered. As a result, the gate-source voltage of the MOS transistors P1 and N1 is raised, thereby causing the current flowing in the MOS transistors P1 and N1 to be increased. Thus, the ineffective current flowing in the MOS transistors P1 and N1 can be kept constant.

In a case where an external circuit is connected to the output terminal OUT, it frequently occurs that a current may flow out to the exterior via the output terminal OUT or a current may flow into the output terminal from the exterior. In this case, the values of the currents flowing in the MOS transistors P1 and N1 become different from each other, and a current flowing in one of the MOS transistors becomes larger than that flowing in the other MOS transistor. For this reason, the level shift amount of the level shift circuit 12 is largely influenced by the magnitude of the output current and there occurs a possibility that the push-pull output circuit may effect an abnormal operation. However, such a possibility may be prevented if the control signal generation circuit 13 has a characteristic of outputting a control signal which is created mainly according to a smaller one of the currents flowing in the MOS transistors P1 and N1. One example of the characteristic is shown in Fig. 6. In Fig. 6, a control signal is created mainly according to a smaller one of the currents flowing in the MOS transistors P1 and N1. When the control signal generation circuit 13 is designed to have a characteristic as shown in Fig. 6, the gate-source voltage VGS of that one of the MOS transistors which permits output or input current flow can be set to be sufficiently high, thus causing a relatively large output current to be derived.

Next, an example of a concrete circuit of the push-pull output circuit shown in the block form in Fig. 3 is explained with reference to Fig. 4. In Fig. 4, portions which are the same as those of Fig. 3 are denoted by the same reference numerals.

In Fig. 4, the level shift circuit 12 is constituted by a variable resistor formed of a P-channel MOS transistor P3 and an N-channel MOS transistor N3 whose current path is connected in parallel with the current path of the MOS transistor P3. The level shift circuit 12 effects the level shift operation according to a voltage drop caused across the current paths of the MOS transistors P3 and N3 by a current from the first constant current source circuit 11.

The control signal generation circuit 13 is constituted by a P-channel MOS transistor P4, a second constant current source circuit 16, a third constant current source circuit 17 and an N-channel MOS transistor N4. The current path of the P-channel MOS transistor P4 and the second constant current source 16 are serially connected between the Vcc potential and the GND potential. Further, the third constant current source circuit 17 and the current path of the N-channel MOS transistor N4 are serially connected between the Vcc potential and the GND potential.

The gate of the P-channel MOS transistor P4 is connected to the connection node Na (the gate of the P-channel MOS transistor P1). The gate of the N-channel MOS transistor N4 is connected to the connection node Nb (the gate of the N-channel MOS transistor N1). Further, a connection node (node Nc) between the P-channel MOS transistor P4 and the second constant current source circuit 16 is connected to the gate of the P-channel MOS transistor P3. A connection node (node Nd) between the third constant current source circuit 17 and the N-channel MOS transistor N4 is connected to the gate of the N-channel MOS transistor N3.

In this embodiment, the ratio of the W (channel width)/L (channel length) ratio of the MOS transistor P1 to a desired ineffective current is set to be the same as the ratio of the W/L ratio of the MOS transistor P4 to an output current of the constant current source circuit 16. Likewise, the ratio of the W/L ratio of the MOS transistor N1 to a desired ineffective current is set to be the same as the ratio of the W/L ratio of the MOS transistor N4 to an output current of the constant current source circuit 17. For example, when the ineffective current is set to 500 mA, the W/L ratio of the MOS transistor P1 is set to 10, and the W/L ratio of the MOS transistor P4 is set to 1, then the output current of the constant current source circuit 16 will be 50 mA.

Further, in this embodiment, the MOS transistors of the same conductivity type are formed in the same step in order to make variations in the characteristics thereof such as variations in the threshold voltages thereof equal to one another.

Next, the operation of the push-pull output circuit shown in Fig. 4 is explained with reference to Figs. 5 to 8.

The basic operation of the circuit shown in Fig. 4 is the same as that of the circuit of Fig. 3 and a signal having a level corresponding to the level of the signal supplied to the input terminal IN is derived from the output terminal OUT.

Next, the operations of the level shift circuit and control signal generation circuit are explained.

First, assume that no load is connected to the output terminal OUT. In this case, the magnitudes of currents flowing in the current paths of the two MOS transistors P1 and N1 of the push-pull output stage circuit are equal to each other.

Now, assume that the power source voltage Vcc is lowered in this condition.

As the power source voltage Vcc is lowered, currents flowing in the MOS transistors N1 and P1 become smaller. As the currents are reduced, the gate-source voltage of the MOS transistor N1 varies. Therefore, the resistance of the current path of the MOS transistor N4 which is applied with the same gate-source voltage as that of the MOS transistor N1 is raised. As a result, the potential of the drain (node Nd) of the MOS transistor N4 is raised. The gate of the N-channel MOS transistor N3 of the level shift circuit 12 is set to the raised potential to reduce the resistance of the current path of the MOS transistor N3.

On the other hand, as the current flowing in the MOS transistor P1 is reduced, the gate-source voltage of the MOS transistor P1 is lowered. Since the same gate-source voltage as that of the MOS transistor P1 is applied to the MOS transistor P4, the resistance of the current path of the MOS transistor P4 increases. As a result, the potential of the drain (node Nc) of the MOS transistor P4 is lowered. Reduction in the potential causes the resistance of the P-channel MOS transistor P3 to be lowered.

Reduction in the resistances of the current paths of the MOS transistors P3 and N3 constituting the level shift circuit 12 causes the potential of the node Na to be lowered, thereby raising the potential of the node Nb. That is, the level shift amount (a potential difference between the nodes Na and Nb) is reduced. Reduction in the level shift amount causes the source-gate voltage of the MOS transistors P1 and N1 to be raised.

As is understood from Fig. 5, with an increase in the source-gate voltage of the MOS transistors P1 and N1, currents flowing in the current paths of the MOS transistors P1 and N1 increase. As a result, a current (ineffective current) flowing in the push-pull output stage circuit can be kept constant irrespective of reduction in the power source voltage.

Next, assume that the power source voltage Vcc becomes high.

With an increase in the power source voltage Vcc, currents flowing in the current paths of the MOS transistors N1 and P1 increase. With an increase in the current flowing in the MOS transistor N1, the gate-source voltage of the MOS transistor N4 is increased. As a result, the resistance of the current path of the MOS transistor N4 is reduced to lower the potential of the drain (node Nd) of the MOS transistor N4. The gate of the N-channel MOS transistor N3 is set to the lowered potential so that the gate-source voltage of the MOS transistor N3 may be reduced and the resistance of the current path of the N-channel MOS transistor N3 will increase.

Further, with an increase in the current flowing in the MOS transistor P1, the gate-source voltage of the MOS transistor P1 increases. Since the same gate-source voltage as that of the MOS transistor P1 is applied to the MOS transistor P4, the resistance of the current path of the MOS transistor P4 increases. As a result, the potential of the drain (node Nc) of the MOS transistor P4 is raised. Rise in the potential causes the resistance of the P-channel MOS transistor P3 to increase.

The potential of the node Na is raised and the potential of the node Nb is lowered with an increase in the resistances of the current paths of the MOS transistors P3 and N3 constituting the level shift circuit 12. That is, the level shift amount is increased. Increase in the level shift amount causes the gate-source voltages of the MOS transistors P1 and N1 to be lowered. As is understood from Fig. 5, with a decrease in the source-gate voltages of the MOS transistors P1 and N1, currents flowing in the MOS transistors P1 and N1 are reduced. As a result, the current can be kept constant irrespective of an increase in the power source voltage Vcc.

Next, consider the operation of a circuit in a case wherein a load is connected to the output terminal OUT. The control signal generation circuit 13 shown in Fig. 4 also has a function of detecting only a smaller one of the currents and outputting a control signal based on the detected current.

For example, when a current is derived out from the output terminal OUT, a current flowing in the MOS transistor P1 becomes larger than that in the MOS transistor N1. With an increase in the current in the MOS transistor P1, the resistance of the current path of the MOS transistor P4 is reduced, and the current in the MOS transistor P4 tends to increase. However, the current is limited to a preset value by means of the constant current source 16. Therefore, the potential of the node Nc is raised. The potential of the node Nc is applied to the gate of the P-channel MOS transistor P3 of the level shift circuit 12 and when the potential of the node Nc becomes equal to or higher than a preset level, the P-channel MOS transistor P3 is turned off. Therefore, even if a current flowing in the MOS transistor P1 becomes extremely large with an increase in the output current, the level shift amount of the level shift circuit 12 is not influenced by the output current when the current flowing in the MOS transistor P1 has exceeded the preset value.

However, even if the MOS transistor P3 is turned off, the potential of the node Nd is controlled by the current flowing in the current path of the MOS transistor N1 to control the resistance of the current path of the MOS transistor N3. As a result, the level shift amount of the level shift circuit 12 is controlled by the current flowing in the MOS transistor N1 to keep the ineffective current flowing in the MOS transistor N1 constituting the push-pull output stage circuit at substantially a constant level.

On the other hand, when a current flows into the output terminal OUT from the exterior, a current flowing in the MOS transistor N1 becomes larger than that in the MOS transistor P1. With an increase in the output current flowing into the output terminal OUT, a current flowing in the MOS transistor N1 increases. With an increase in the current flowing in the MOS transistor N1, the resistance of the current path of the MOS transistor N4 is lowered to lower the potential of the node Nd. When the potential of the node Nd becomes equal to or lower than a preset level, the N-channel MOS transistor N3 is turned off. Therefore, even if a current flowing in the MOS transistor N1 becomes large with an increase in the current flowing into the output terminal, the level shift amount of the level shift circuit 12 is not influenced by the input current when the current flowing in the MOS transistor N1 has exceeded a preset value.

However, even if the MOS transistor N3 is turned off, the potential of the node Nc is controlled by the current flowing in the current path of the MOS transistor P1 to control the resistance of the current path of the MOS transistor P3. As a result, the level shift amount of the level shift circuit 12 is controlled by the current flowing in the MOS transistor P1 to keep the ineffective current flowing in the MOS transistor P1 and N1 constituting the push-pull output stage circuit at substantially a constant level.

As described above, according to the push-pull output circuit shown in Figs. 3 and 4, the ineffective current can be kept at substantially a constant value even if the power source voltage and the characteristics of the MOS transistors have varied. Further, influence on the control signal generation circuit 13 by currents flowing out from the output terminal or flowing into the output terminal from the exterior can be removed.

Now, the characteristic of the push-pull output circuit shown in Fig. 4 is explained in comparison with that of the conventional case.

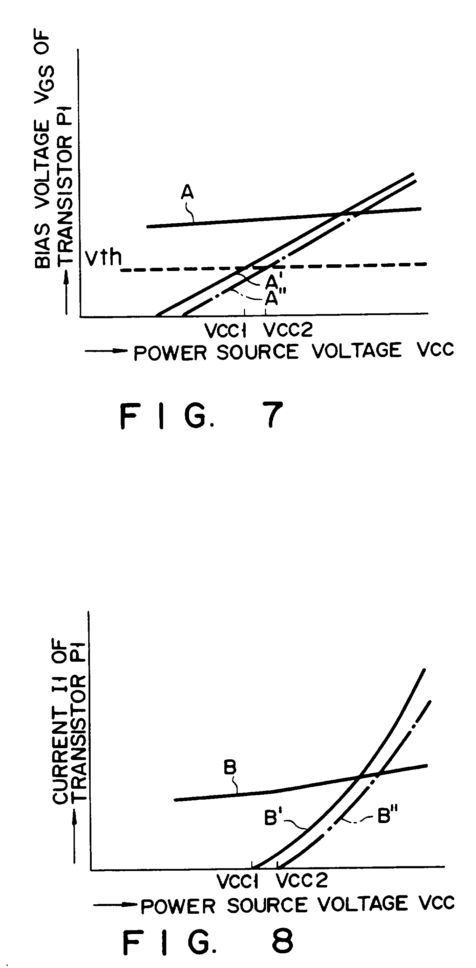

A curve A in Fig. 7 indicates the relation between the gate-source voltage VGS of the MOS transistor P1 of the push-pull output circuit shown in Fig. 4 and the power source voltage Vcc. For comparison, the relations between the gate-source voltage VGS of the MOS transistor P1 of the conventional push-pull output circuit shown in Fig. 1 and the power source voltage Vcc are indicated by curves A' and A". Further, a curve Vth indicates variation in the threshold voltage of the MOS transistor P1.

On the other hand, a curve B of Fig. 8 indicates the relation between the ineffective current I1 in the MOS transistor P1 of the push-pull output circuit shown in Fig. 4 and the power source voltage Vcc. For comparison, the relations between the ineffective current I1 in the MOS transistor P1 of the push-pull output circuit shown in Fig. 1 and the power source voltage Vcc are indicated by curves B' and B".

The inclination of the characteristic curve A in Fig. 7 and the inclination of the characteristic curve B in Fig. 8 indicate variation in the current of the current source circuits 11, 16 and 17 in the push-pull output circuit of Fig. 4 and variation in the drain-source voltage of the MOS transistor P1.

As is clearly seen from Figs. 7 and 8, according to this invention, the bias voltage VGS and ineffective current I1 are kept substantially constant irrespective of variation in the power source voltage Vcc. In contrast, in the push-pull output circuit of Fig. 1, the bias voltage VGS of the MOS transistor P1 varies with the power source voltage Vcc as indicated by the characteristic curve A'. Further, in the circuit of Fig. 1, the ineffective current I1 of the MOS transistor P1 exhibits the quadrant characteristic as indicated by the characteristic curve B' of Fig. 8 when the bias voltage VGS has exceeded the threshold voltage Vth of the MOS transistor P1.

The curve A" of Fig. 7 shows a case wherein the threshold voltage Vth of the P-channel MOS transistor P1 has varied and indicates the bias voltage VGS of the P-channel MOS transistor P1 with the threshold voltage Vth set as a reference value. In this case, as shown by the curve B" of Fig. 8, the ineffective current I1 is significantly varied.

As is seen from Figs. 7 and 8, according to this embodiment, even when the threshold voltage Vth of the P-channel MOS transistor P1 of the push-pull output stage circuit has varied, the threshold voltage Vth of the P-channel MOS transistor P4 varies in the same manner so that the gate-source voltage of the P-channel MOS transistor P3 of the level shift circuit 12 will be kept unchanged and a voltage of the bias node Na can be kept unchanged.

The construction of the push-pull output circuit is not limited to the above embodiment. For example, an anti-oscillation circuit can be added to the above circuit, and it is also possible to set the size of the P-channel MOS transistor P4 and N-channel MOS transistor N4 to, for example, twice that of the MOS transistors P1 and N1 in order to enhance the sensitivity of detecting currents flowing in the two MOS transistors P1 and N1 of the push-pull output stage circuit.

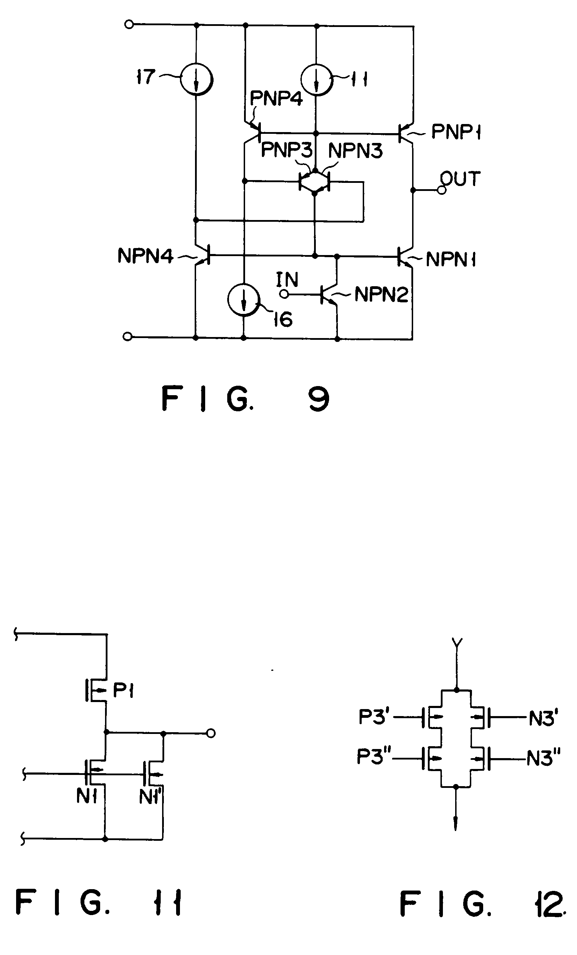

Further, in the above embodiment, MOS transistors are used as transistors, but it is also possible to use bipolar transistors or BiCMOS technique to constitute the circuits as shown in Figs. 9 and 10. In the construction of Fig. 9, substantially the same effect as that of the above embodiment can be obtained. Further, elements other than the MOS transistors and bipolar transistors may be used.

The MOS transistors of the same conductivity type are preferably formed in the same step in order to make equal variations in the characteristics such as variations in the threshold voltages. However, they may be formed in different steps.

Further, in a case where a signal of a certain level is supplied to the input terminal IN, it is also possible to exchange the power source potential Vcc and the ground potential GND with each other, reverse the direction of flow of the current of the current source circuit and change the conductivity types of the transistors (for example, use P-channel and N-channel MOS transistors instead of the N-channel and P-channel MOS transistors, respectively).

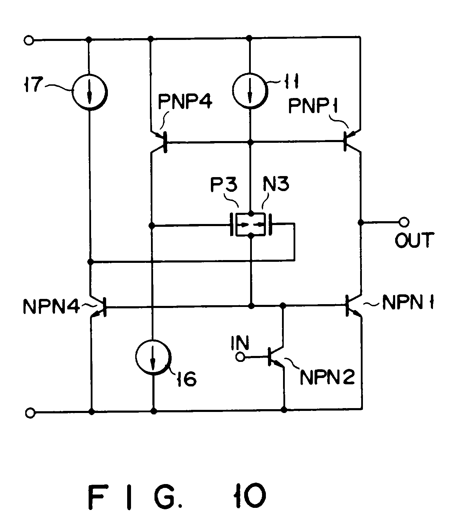

For example, the output stage circuit may be formed as shown in Fig. 11, and the level shift circuit may be formed as shown in Fig. 12. Further, the control signal generation circuit may be constructed to perform the operation based on data from the ammeters 14 and 15 so as to control the level shift amount, for example.

According to the above embodiments of this invention, it is possible to provide a push-pull output circuit which has a large amplitude characteristic, less distortion characteristic and large output current characteristic and is less influenced by variations in the power source voltage and the characteristics of transistors.

Reference signs in the claims are intended for better understanding and shall not limit the scope.

## Claims

1. A push-pull circuit, comprising
an input terminal (IN);
an output terminal (OUT);
an output stage circuit connected between a first potential (Vcc) and a second potential (GND) and having a first transistor (P1; PNP1) of a first conductivity type, a second transistor (N1; NPN1) of a second conductivity type whose current paths are serially connected, and said output terminal (OUT) connected to drain terminals of said first transistor (P1; PNP1) and said second transistor (N1; NPN1);
a level shift circuit (12) having a third transistor (P3; PNP3) of the first conductivity type and a fourth transistor (N3; NPN3) whose current path is connected in parallel with the current path of said third transistor (P3; PNP3) of the first conductivity type;
a control circuit (13) having a fifth transistor (P4; PNP4) of the first conductivity type and a first current source circuit (16) which are serially connected between said first and second potentials, and a second current source circuit (17) and a sixth transistor (N4; NPN4) of the second conductivity type which are serially connected between said first and second potentials;
wherein a control terminal of said fifth transistor (P4; PNP4) of the first conductivity type is connected to a control terminal of said first transistor (P1; PNP1) of the first conductivity type;
wherein a control terminal of said sixth transistor (N4; NPN4) of the second conductivity type is connected to a control terminal of said second transistor (N1; NPN1) of the second conductivity type;
wherein a connection node between said fifth transistor (P4; PNP4) of the first conductivity type and said first current source circuit (16) is connected to a control terminal of said third transistor (P3; PNP3) of the first conductivity type; and
wherein a connection node between said second current source circuit (17) and said sixth transistor (N4; NPN4) of the second conductivity type is connected to a control terminal of said fourth transistor (N3; NPN3);
**characterized** in that
said fourth transistor (N3; NPN3) is of the second conductivity type;
the drain terminal of said third transistor (P3; PNP3) and the source terminal of said fourth transistor (N3; NPN3) are connected together, as are the source terminal of said third transistor (P3; PNP3) and the drain terminal of said fourth transistor (N3; NPN3), these two connections, respectively, forming first and second common ports;
said first and second common ports being respectively connected directly to the interconnected control terminals of said first and fifth transistors (P1; PNP1, P4; PNP4) and second and sixth transistors (N1; NPN1, N4; NPN4);
a third current source (11) is connected between said level shift circuit (12) and said first potential (Vcc); and
an output controlling transistor (N2; NPN2) has a current path connected between the second common part of said level shift circuit (12) and said second potential (GND), and is connected by its control terminal to said input terminal (IN).

2. The push-pull circuit according to claim 1, characterized in that
the ratio of the channel width/ channel length ratio of said first transistor (P1; PNP1) of the first conductivity type to a desired ineffective current is substantially equal to the ratio of the channel width/channel length ratio of said fifth transistor (P4; PNP4) of the first conductivity type to an output current of said first current source circuit (16); and
the ratio of the channel width/ channel length ratio of said second transistor (N1; NPN1) of the second conductivity type to a desired ineffective current is substantially equal to the ratio of the channel width/channel length ratio of said sixth transistor (N4; NPN4) of the second conductivity type to an output current of said second current source circuit (17).

3. The push-pull circuit according to anyone of the preceding claims, characterized in that said control circuit (13) comprises current detecting circuits (14, 15) respectively connected to said first and second transistors (P1, N1) for detecting current levels of the currents flowing in said first and second transistors (P1, N1).

4. The push-pull circuit according to anyone of the preceding claims, characterized in that said level shift circuit (12) and said control circuit (13) form current level detecting and potential difference setting means, for detecting a current level of at least one of currents flowing in said first and second transistors (P1; PNP1, N1; NPN1), and for setting a potential difference between signals supplied to control terminals of said first and second transistors (P1; PNP1, N1; PNP1) according to the result of detection.

5. A push-pull circuit according to claim 4, characterized in that said potential difference setting means includes means for raising the potential when the currents flowing in said first and second transistors (P1; PNP1, N1; PNP1) have increased and lower the potential when the curreent flowing in said first and second transistors (P1; PNP1, N1; PNP1) have decreased.

6. A push-pull circuit according to claim 4, characterized in that said potential difference setting means includes means for controlling the bias voltage applied to said first and second transistors (P1; PNP1, N1; PNP1) to keep at constant values irrespective of whether the currents flowing in said first and second transistors (P1; PNP1, N1; PNP1) have increased or decreased.

7. A push-pull circuit according to claim 4, characterized in that said potential difference setting means controls the potential according to a smaller one of the currents flowing in said first and second transistors (P1; PNP1, N1; PNP1).

8. The push-pull circuit according to anyone of the preceding claims, characterized in that said third current source (11), said level shift circuit (12) and said control circuit (13) are provided for keeping an ineffective current flowing in said push-pull circuit at a substantially constant value.

9. A push-pull output circuit according to any one of the preceding claims, characterized in that said first potential (Vcc) is a power source potential and said second potential (GND) is a ground potential.

10. The push-pull circuit according any one of claims 1 to 9, characterized in that said first to sixth transistors are formed of MOS transistors.

11. The push-pull circuit according any one of claims 1 to 9, characterized in that said first to sixth transistors are formed of bipolar transistors.

## Patentansprüche

1. Gegentaktschaltung, umfassend:
einen Eingangsanschluß (EIN);
einen Ausgangsanschluß (AUS);
eine Ausgangsstufenschaltung, die zwischen ein erstes Potential (Vcc) und ein zweites Potential (GND) geschaltet ist und einen ersten Transistor (P1; PNP1) eines ersten Leitfähigkeitstyps, einen zweiten Transistor (N1; NPN1) eines zweiten Leitfähigkeitstyps aufweist, deren Strompfade in Reihe geschaltet sind, und wobei der Ausgangsanschluß (AUS) mit den Drain-Anschlüssen des ersten Transistors (P1; PNP1) und des zweiten Transistors (N1; NPN1) verbunden sind;
eine Pegelverschiebungsschaltung (12) mit einem dritten Transistor (P3; PNP3) des ersten Leitfähigkeitstyps und einem vierten Transistor (N3; NPN3), dessen Strompfad parallel zu dem Strompfad des dritten Transistors (P3; PNP3) des ersten Leitfähigkeitstyps geschaltet ist;
eine Steuerschaltung (13) mit einem fünften Transistor (P4; PNP4) des ersten Leitfähigkeitstyps und einer ersten Stromquellenschaltung (16), die zwischen die ersten und zweiten Potentiale in Reihe geschaltet sind, und mit einer zweiten Stromquellenschaltung (17) und einem sechsten Transistor (N4; NPN4) des zweiten Leitfähigkeitstyps, die zwischen die ersten und zweiten Potentiale in Reihe geschaltet sind;
wobei ein Steueranschluß des fünften Transistors (P4; PNP4) des ersten Leitfähigkeitstyps mit einer Steueranschluß des ersten Transistors (P1; PNP1) des ersten Leitfähigkeitstyps verbunden ist;
wobei ein Steueranschluß des sechsten Transistors (N4; NPN4) des zweiten Leitfähigkeitstyps mit einem Steueranschluß des zweiten Transistors (N1; NPN1) des zweiten Leitfähigkeitstyps verbunden ist;
wobei ein Verbindungsknoten zwischen dem fünften Transistor (P4; PNP4) des ersten Leitfähigkeitstyps und der ersten Stromquellenschaltung (16) mit einem Steueranschluß des dritten Transistors (P3; PNP3) des ersten Leitfähigkeitstyps verbunden ist; und
wobei ein Verbindungsknoten zwischen der zweiten Stromquellenschaltung (17) und dem sechsten Transistor (N4; NPN4) des zweiten Leitfähigkeitstyps mit einem Steueranschluß des vierten Transistors (N3; NPN3) verbunden ist;
dadurch gekennzeichnet, daß
der vierte Transistor (N3; NPN3) von dem zweiten Leitfähigkeitstyp ist;
der Drain-Anschluß des dritten Transistors (P3; PNP3) und der Source-Anschluß des vierten Transistors (N3; NPN3) zusammengeschaltet sind, genauso wie der Source-Anschluß des dritten Transistors (P3; PNP3) und der Drain-Anschluß des vierten Transistors (N3; NPN3), wobei diese beiden Verbindungen jeweils erste und zweite gemeinsame Ports bilden;
wobei die ersten und zweiten gemeinsamen Ports jeweils direkt mit den zusammengeschalteten Steueranschlüssen der ersten und fünften Transistoren (P1; PNP1, P4; PNP4) der zweiten und sechsten Transistoren (N1; NPN1, N4; NPN4) verbunden sind;
eine dritte Stromquelle (11) zwischen die Pegelverschiebungsschaltung (12) und das erste Potential (Vcc) geschaltet ist; und
ein Ausgangs-Steuertransistor (N2; NPN2) einen Strompfad aufweist, der zwischen den zweiten gemeinsamen Teil der Pegelverschiebungsschaltung (12) und das zweite Potential (GND) geschaltet ist, und mit seinem Steueranschluß mit dem Eingangsanschluß (EIN) verbunden ist.

2. Gegentaktschaltung nach Anspruch 1, dadurch gekennzeichnet, daß
das Verhältnis des Kanalbreiten/Kanallängen-Verhältnisses des ersten Transistors (P1; PNP1) des ersten Leitfähigkeitstyps zu einem gewünschten ineffektiven Strom im wesentlichen gleich zu dem Verhältnis des Kanalbreiten/Kanallängen-Verhältnisses des fünften Transistors (P4; PNP4) des ersten Leitfähigkeitstyps zu einem Ausgangsstrom der ersten Stromquellenschaltung (16) ist; und
das Verhältnis des Kanalbreiten/Kanallängen-Verhältnisses des ersten Transistors (N1; NPN1) des zweiten Leitfähigkeitstyps zu einem gewünschten ineffektiven Strom im wesentlichen gleich zu dem Verhältnis des Kanalbreiten/Kanallängen-Verhältnisses des sechsten Transistors (N4; NPN4) des zweiten Leitfähigkeitstyps zu einem Ausgangsstrom der zweiten Stromquellenschaltung (17) ist.

3. Gegentaktschaltung nach einem der vorangehenden Ansprüche, dadurch gekennzeichnet, daß die Steuerschaltung (13) Stromerfassungsschaltungen (14, 15) umfaßt, die mit dem ersten bzw. zweiten Transistor (P1, N1) verbunden sind, zum Erfassen von Strompegeln der Ströme, die in den ersten und zweiten Transistoren (P1, N1) fließen.

4. Gegentaktschaltung nach einem der vorangehenden Ansprüche, dadurch gekennzeichnet, daß die Pegelverschiebungsschaltung (12) und die Steuerschaltung (13) eine Strompegelerfassungs- und PotentialdifferenzEinstelleinrichtung bilden, zum Erfassen eines Strompegels von wenigstens einem Strom von Strömen, die in den ersten und zweiten Transistoren (P1; PNP1, N1; NPN1) fließen, und zum Einstellen einer Potentialdifferenz zwischen Signalen, die an Steueranschlüsse der ersten und zweiten Transistoren (P1; PNP1, N1; PNP1) geliefert werden, entsprechend dem Ergebnis einer Erfassung.

5. Gegentaktschaltung nach Anspruch 4, dadurch gekennzeichnet, daß die Potentialdifferenzeinstelleinrichtung eine Einrichtung umfaßt, zum Erhöhen des Potentials, wenn die in den ersten und zweiten Transistoren (P1; PNP1, N1; PNP1) fließenden Ströme zugenommen haben, und zum Verringern des Potentials, wenn die in den ersten und zweiten Transistoren (P1; PNP1, N1; PNP1) fließenden Ströme abgenommen haben.

6. Gegentaktschaltung nach Anspruch 4, dadurch gekennzeichnet, daß die Potentialdifferenzeinstelleinrichtung eine Einrichtung umfaßt, zum Steuern der an die ersten und zweiten Transistoren (P1; PNP1, N1; PNP1) angelegten Vorspannung, um konstante Werte unabhängig davon aufrechtzuerhalten, ob die in den ersten und zweiten Transistoren (P1; PNP1, N1; PNP1) fließenden Ströme zugenommen oder abgenommen haben.

7. Gegentaktschaltung nach Anspruch 4, dadurch gekennzeichnet, daß die Potentialdifferenzeinstelleinrichtung das Potential entsprechend einem kleineren Strom der in den ersten und zweiten Transistoren (P1; PNP1, N1; PNP1) fließenden Ströme steuert.

8. Gegentaktschaltung nach einem der vorangehenden Ansprüche, dadurch gekennzeichnet, daß die dritte Stromquelle (11), die Pegelverschiebungsschaltung (12) und die Steuerschaltung (13) vorgesehen sind, um einen in der Gegentaktschaltung fließenden ineffektiven Strom auf einem im wesentlichen konstanten Wert zu halten.

9. Gegentakt-Ausgangsschaltung nach einem der vorangehenden Ansprüche, dadurch gekennzeichnet, daß das erste Potential (Vcc) ein Energiequellenpotential und das zweite Potential (GND) ein Massepotential ist.

10. Gegentaktschaltung nach einem Ansprüche 1 bis 9, dadurch gekennzeichnet, daß die ersten bis sechsten Transistoren aus MOS-Transistoren gebildet sind.

11. Gegentaktschaltung nach einem der Ansprüche 1 bis 9, dadurch gekennzeichnet, daß die ersten bis sechsten Transistoren aus Bipolartransistoren gebildet sind.

## Revendications

1. Circuit push-pull, comprenant :
une borne d'entrée (IN) ;
une borne de sortie (OUT) ;
un circuit d'étage de sortie relié entre un premier potentiel (Vcc) et un second potentiel (GND) et ayant un premier transistor (P1 ; PNP1) d'un premier type de conductivité, un second transistor (N1 ; NPN1) d'un second type de conductivité dans lesquels des chemins de courant sont reliés en série, et ladite borne de sortie (OUT) reliée aux bornes de drain dudit premier transistor (P1 ; PNP1) et dudit second transistor (N1 ; NPN1) ;
un circuit de décalage de niveau (12) ayant un troisième transistor (P3 ; PNP3) du premier type de conductivité et un quatrième transistor (N3 ; NPN3) dans lesquels un chemin de courant est relié en parallèle au chemin de courant dudit troisième transistor (P3 ; PNP3) du premier type de conductivité ;
un circuit de commande (13) ayant un cinquième transistor (P4 ; PNP4) du premier type de conductivité et un premier circuit de source de courant (16) qui sont reliés en série entre lesdits premier et second potentiels, et un second circuit de source de courant (17) et un sixième transistor (N4 ; NPN4) du second type de conductivité qui sont reliés en série entre lesdits premier et second potentiels ;
dans lequel une borne de commande dudit cinquième transistor (P4 ; PNP4) du premier type de conductivité est reliée à une borne de commande dudit premier transistor (P1 ; PNP1) du premier type de conductivité ;
dans lequel une borne de commande dudit sixième transistor (N4 ; NPN4) du second type de conductivité est reliée à une borne de commande dudit second transistor (N1 ; NPN1) du second type de conductivité ;
dans lequel un noeud de connexion entre ledit cinquième transistor (P4 ; PNP4) du premier type de conductivité et ledit premier circuit de source de courant (16) est relié à une borne de commande dudit troisième transistor (P3 ; PNP3) du premier type de conductivité ; et
dans lequel un noeud de connexion entre ledit second circuit de source de courant (17) et ledit sixième transistor (N4 ; NPN4) du second type de conductivité est relié à une borne de commande dudit quatrième transistor (N3 ; NPN3) ;
caractérisé en ce que
ledit quatrième transistor (N3 ; NPN3) est du second type de conductivité ;
la borne de drain dudit troisième transistor (P3 ; PNP3) et la borne de source dudit quatrième transistor (N3 ; NPN3) sont reliées ensemble, comme le sont la borne de source dudit troisième transistor (P3 ; PNP3) et la borne de drain dudit quatrième transistor (N3 ; NPN3), ces deux connexions, respectivement, formant des premier et second ports communs ;
lesdits premier et second ports communs étant respectivement reliés directement aux bornes de commande interconnectées desdits premier et cinquième transistors (P1 ; PNP1, P4 ; PNP4) et desdits second et sixième transistors (N1 ; NPN1, N4 ; NPN4) ;
une troisième source de courant (11) est reliée entre ledit circuit de décalage de niveau (12) et ledit premier potentiel (Vcc) ; et
un transistor de commande de sortie (N2 ; NPN2) a un chemin de courant relié entre la seconde partie commune dudit circuit de décalage de niveau (12) et ledit second potentiel (GND), et est relié par sa borne de commande à ladite borne d'entrée (IN).

2. Circuit push-pull selon la revendication 1, caractérisé en ce que
le rapport du rapport de largeur de canal/ longueur de canal dudit premier transistor (P1 ; PNP1) du premier type de conductivité sur un courant inefficace voulu est substantiellement égal au rapport du rapport de largeur de canal/longueur de canal dudit cinquième transistor (P4 ; PNP4) du premier type de conductivité sur un courant de sortie dudit premier circuit de source de courant (16) ; et
le rapport du rapport de largeur de canal/ longueur de canal dudit second transistor (N1 ; NPN1) du second type de conductivité sur un courant inefficace voulu est substantiellement égal au rapport du rapport de largeur de canal/longueur de canal dudit sixième transistor (N4 ; NPN4) du second type de conductivité sur un courant de sortie dudit second circuit de source de courant (17).

3. Circuit push-pull selon l'une quelconque des revendications précédentes, caractérisé en ce que ledit circuit de commande (13) comprend des circuits de détection de courant (14, 15) respectivement reliés auxdits premier et second transistors (P1, N1) pour détecter des niveaux de courant des courants passant dans lesdits premier et second transistors (P1, N1).

4. Circuit push-pull selon l'une quelconque des revendications précédentes, caractérisé en ce que ledit circuit de décalage de niveau (12) et ledit circuit de commande (13) forment un dispositif de détection de niveau de courant et de réglage de différence de potentiel, pour détecter un niveau de courant d'au moins un des courants passant dans lesdits premier et second transistors (P1 ; PNP1, N1 ; NPN1), et pour régler une différence de potentiel entre des signaux appliqués aux bornes de commande desdits premier et second transistors (P1 ; PNP1, N1 ; NPN1) selon le résultat de la détection.

5. Circuit push-pull selon la revendication 4, caractérisé en ce que ledit dispositif de réglage de différence de potentiel comprend un dispositif pour élever le potentiel lorsque les courants passant dans lesdits premier et second transistors (P1 ; PNP1, N1 ; PNP1) ont augmenté et abaisse le potentiel lorsque les courants passant dans lesdits premier et second transistors (P1 ; PNP1, N1 ; PNP1) ont diminué.

6. Circuit push-pull selon la revendication 4, caractérisé en ce que ledit dispositif de réglage de différence de potentiel comprend un dispositif pour commander la tension de polarisation appliquée auxdits premier et second transistors (P1 ; PNP1, N1 ; PNP1) pour la maintenir à des valeurs constantes indépendamment de si les courants passant dans les premier et second ((P1 ; PNP1, N1 ; PNP1) ont augmenté ou diminué.

7. Circuit push-pull selon la revendication 4, caractérisé en ce que ledit dispositif de réglage de différence de potentiel commande le potentiel selon le plus petit des courants passant dans lesdits premier et second transistors (P1 ; PNP1, N1 ; PNP1).

8. Circuit push-pull selon l'une quelconque des revendications précédentes, caractérisé en ce que ladite troisième source de courant (11), ledit circuit de décalage de niveau (12) et ledit circuit de commande (13) sont fournis pour maintenir un courant inefficace passant dans ledit circuit push-pull à une valeur substantiellement constante.

9. Circuit de sortie push-pull selon l'une quelconque des revendications précédentes, caractérisé en ce que ledit premier potentiel (Vcc) est un potentiel de source d'alimentation et ledit second potentiel (GND) est un potentiel de masse.

10. Circuit push-pull selon l'une quelconque des revendications 1 à 9, caractérisé en ce que lesdits premier au sixième transistors sont formés de transistors MOS.

11. Circuit push-pull selon l'une quelconque des revendications 1 à 9, caractérisé en ce que lesdits premier au sixième transistors sont formés de transistors bipolaires.
